# EUROPÄISCHE PATENTSCHRIFT

(11) **EP 3 002 997 B1**
(45) Veröffentlichungstag und Bekanntmachung des Hinweises auf die Patenterteilung: **27.02.2019**
(21) Anmeldenummer: 15187605.9
(22) Anmeldetag: 30.09.2015
(51) Int. Cl.: H05K 3/20, H05K 3/30, H05K 3/40, H01R 12/53, H01R 12/69

(54) **ELEKTRISCHES BAUTEIL MIT EINEM EINGRIFFSELEMENT**
ELECTRIC COMPONENT HAVING AN ANCHORING ELEMENT
COMPOSANT ELECTRIQUE AYANT UN ELEMENT D'ANCRAGE

(30) Priorität: 30.09.2014 DE 102014114252
(43) Veröffentlichungstag der Anmeldung: 06.04.2016
(73) Patentinhaber: Sonderbau Simmet Kabeltechnik GmbH, 66280 Sulzbach (DE)
(72) Erfinder: Simmet, Klaus, 66440 Blieskastel (DE)
(74) Vertreter: Katscher Habermann Patentanwälte

(56) Entgegenhaltungen:
- EP-A1- 1 867 912
- WO-A1-2014/077119
- FR-A1- 2 662 324
- US-A- 3 257 537
- US-A1- 2002 112 879
- US-A1- 2003 099 099
- US-A1- 2014 120 786
- US-B1- 6 353 189

## Beschreibung

Die Erfindung betrifft ein elektrisches Bauteil zur elektrischen Anbringung an einer Leiterplatte, wobei das elektrische Bauteil mindestens ein selbstschneidendes Eingriffsmittel aufweist, wobei das Eingriffsmittel in die Leiterplatte eindringt, wenn das elektrische Bauteil an die Leiterplatte angedrückt wird, um das elektrische Bauteil an der Leiterplatte festzulegen.

Aus dem Stand der Technik sind unterschiedliche Möglichkeiten bekannt, ein elektrisches Bauteil an einer Leiterplatte anzuordnen oder mit dieser elektrisch leitend zu verbinden. Ein elektrisches Bauteil ist beispielsweise ein Bestandteil einer elektrischen Schaltung, wie ein elektrischer Widerstand oder eine Lötfahne.

Das Bauteil kann mittels Lötkontakte an der Leiterplatte angebracht werden, die auf einer Leiterplatte beispielsweise auf ein Kontaktpad oder einer Kontaktstelle einer Leiterplatte gelötet werden. Diese Kontakte unterliegen beim Transport und der Bearbeitung unterschiedlichen mechanischen und thermischen Beanspruchungen. Die bekannten Lötkontakte dienen vorzugsweise der elektrischen oder mechanischen Verbindung beispielsweise eines Widerstandes mit einer Leiterplatte oder mit einem Drahtanschluss eines zugehörigen elektrischen oder elektronischen Gerätes.

Es sind jedoch auch Leiterplatten aus Materialien bekannt, die aufgrund von materialspezifischen Eigenschaften ein festlöten von Bauteilen nicht ermöglichen. Alternativ zum Löten kann das Bauteil mithilfe von Befestigungsmitteln, wie beispielsweise Nieten, Klammern oder dergleichen an der Leiterplatte befestigt werden. Es hat sich gezeigt, dass eine solche Befestigung zwar den mechanischen Ansprüchen weitgehend genügt, jedoch kann eine gute Kontaktierung nicht immer gewährleistet werden.

Um die Kontaktsicherheit zu erhöhen, können Zusatzmittel wie beispielsweise Kontaktsilber oder Kontaktkleber verwendet werden, die zwischen dem Bauteil und der Leiterplatte eingesetzt werden. Hierdurch kann eine kontaktlose Verbindung in der Regel vermieden werden.

Die Befestigung eines Bauteils insbesondere an einer nicht lötbaren Leiterplatte erfordert in der Regel, dass eine Aufnahme oder Ausnehmung für das Bauteil in der Leiterplatte vorliegt, damit eine solide mechanische Verbindung hergestellt werden kann. Hierfür werden die Lötplatten vorgestanzt, so dass in diese Ausstanzungen bei der Befestigung des Bauteils entsprechende Befestigungsmittel, wie beispielsweise Nieten, eingebracht werden können. Das Vorstanzen der Leiterplatte benötigt jedoch einen zusätzlichen Arbeitsschritt mit einem speziellen Werkzeug und führt zusätzlich zu einer mechanischen Belastung der Leiterplatte. Es hat sich gezeigt, dass der Ausschluss beschädigter Leiterplatten hoch ist, da durch die mechanische Belastung der Leiterplatte durch das Stanzwerkzeug Verformungen der Leiterplatte entstehen, die einen späteren Funktionsverlust nach sich ziehen können. Ferner können die Bauteile nur in solchen Positionen an der Leiterplatte befestigt werden, die bereits vorgestanzt sind. Eine flexible Montage der Bauteile ist nur dann möglich, wenn die Bauteile direkt ein Befestigungsmittel aufweisen, wobei auch in diesem Fall eine Aufnahme auf der Leiterplatte vorliegen muss, in die das Bauteil eingefügt wird.

Auch die Verwendung von Schraubverbindungen zur Befestigung eines Bauteils an der Leiterplatte ist als nachteilig anzusehen. Zum einen kann es leicht zu Montagefehlern beim Zusammenbau kommen und zum anderen sind Schraubprozesse trotz moderner Elektroschrauber immer noch als kritisch einzustufen. Zum Beispiel kann es zu einem Schraubenabriss oder nicht richtig angezogener Schrauben kommen, was zur Erhöhung des elektrischen Übergangswiderstandes der Masseanbindung und Ausfällen, insbesondere bei Stößen, führen kann. Darüber hinaus sind manuelle Schraubprozesse sowie deren Vollautomatisierung vergleichsweise kostenintensiv.

Beispielsweise aus FR 2 662 324 A1 ist ein elektrisches Bauteil bekannt, das mindestens ein selbstschneidendes Eingriffsmittel aufweist, wobei das Eingriffsmittel in die Leiterplatte eindringt, wenn das elektrische Bauteil an die Leiterplatte angedrückt wird, um das elektrische Bauteil an der Leiterplatte festzulegen. Das elektrische Bauteil ist dabei als Klammer ausgebildet, die in die Leiterplatte eingedrückt werden kann. In EP 1 867 912 A1 wird ebenfalls eine vergleichbare Klammer beschrieben, mit der Anschlussdrähte für ein weiteres elektrisches Bauteil wie beispielsweise eine LED auf der Leiterplatte festgelegt und elektrisch kontaktiert werden können. Weitere Ausgestaltungen derartiger elektrischer Bauteile mit selbstschneidenden Eingriffsmitteln sind beispielsweise in US 3 257 537 A, WO 2014/077119 A1, US 2002/112879 A1, US 6 353 189 B1 oder US 2003/099099 A1 gezeigt und beschrieben.

Mit den aus dem Stand der Technik bekannten klammerartigen elektrischen Bauteilen kann ein elektrischer Leiter wie beispielsweise ein Draht oder eine Litze nur zwischen dem elektrischen Bauteil und der Leiterplatte klemmend festgelegt werden, womit ein hoher Montageaufwand verbunden ist.

Es ist daher die Aufgabe der Erfindung, mit einfachen und kostengünstigen Mitteln eine zuverlässige elektrisch leitende Festlegung eines elektrischen Leiters an der Leiterplatte zu ermöglichen. Die Befestigung soll eine ausreichende mechanische Festigkeit besitzen und eine zuverlässige elektrische Masseanbindung beispielsweise eines Drahts oder einer Litze an der Leiterplatte ermöglichen.

Gelöst wird die Aufgabe erfindungsgemäß dadurch, dass das elektrische Bauteil beabstandet zu den Eingriffsmitteln einen Kopfbereich zur elektrisch leitenden Festlegung eines elektrischen Leiters an dem elektrischen Bauteil aufweist.

Das Bauteil kann insbesondere als Lötfahne ausgestaltet sein. Eine Lötfahne, die im Sinne der Erfindung auch als Lötöse bezeichnet werden kann, ist insbesondere ein Bauteil, mit dem ein Draht oder eine Litze elektrisch leitend an einer Leiterplatte befestigt werden kann. Die Lötfahne weist neben einem Eingriffsmittel und vorzugsweise einem Kontaktbereich einen Kopfbereich auf, an dem ein Draht festlegbar ist. Der Draht kann beispielsweise an dem Kopfbereich mittels Löten oder mittels Befestigungsmittel festgelegt werden. Der Kopfbereich kann relativ zu einem Bereich, in dem das Eingriffsmittel langeordnet ist, abgewinkelt sein.

Es ist ebenfalls möglich, dass das Bauteil einen Kopfbereich mit einer Basisplatte und mit seitlich abstehenden Befestigungszungen aufweist, die um einen zwischen den Befestigungszungen angeordneten elektrischen Leiter gebogen und zusammengepresst werden können, um eine mechanisch stabile und elektrisch leitende Befestigung des elektrischen Leiters an dem Bauteil zu erleichtern. Der elektrische Leiter kann beispielsweise ein Draht oder eine Litze sein, wobei beliebige elektrisch leitende Leiter oder Verbindungselemente möglich sind. Wenn die zusammengebogenen Befestigungszungen einen isolierten Abschnitt des Drahts oder der Litze umgreifen, dienen die Befestigungszungen ausschließlich einer mechanisch stabilen Festlegung des elektrischen Leiters an dem Bauteil. Der elektrisch leitende Kontakt muss dann in einem abisolierten Bereich des elektrischen Leiters vorgenommen werden und kann gesondert ausgeführt werden.

Es ist auch möglich, zwischen den Befestigungszungen einen nicht isolierten Abschnitt des elektrischen Leiters anzuordnen und über die eng an dem Draht oder an der Litze anliegenden zusammengepressten Befestigungszungen eine elektrisch leitende Verbindung herzustellen. Die Befestigungszungen können zudem so ausgebildet und beispielsweise mit scharfkantigen Ecken oder Eingriffselementen ausgestaltet sein, dass die Befestigungszungen bei einem Verpressen an dem elektrischen Leiter in eine gegebenenfalls vorhandene Kunststoffisolierung eindringen und einen elektrisch leitenden Kontakt mit dem Draht oder der Litze herstellen würden.

Die beiden Befestigungszungen können auch lediglich als zusätzliche Anlagefläche und als mechanischer Schutz für einen anderweitig im Kopfbereich befestigten elektrischen Leiter dienen. Es ist ebenfalls möglich, dass der Kopfbereich als Steckkontaktelement ausgebildet ist und ein elektrischer Leiter, an dessen Ende ein daran angepasstes Steckkontaktelement angeordnet ist, auf den Kopfbereich aufgeschoben und beispielsweise klemmend oder rastend festgelegt wird.

Das Bauteil kann im Sinne der Erfindung ein Bestandteil einer elektrischen Schaltung sein, beispielsweise eine Anschlussleitung, ein Widerstand, ein Schalter, ein Relais, ein Kondensator, eine Spule, ein Transformator, ein Sensor, ein Sender, ein Empfänger oder eine Lötfahne. Das Bauteil kann insbesondere selbst elektrisch leitend sein oder Bestandteile enthalten, die wiederum elektrisch leitend sind.

Das Bauteil weist ein selbstschneidendes Eingriffsmittel auf. Selbstschneidend bezeichnet im Sinne der Erfindung, dass das Eingriffsmittel derart ausgestaltet ist, dass das Eingriffsmittel in die Leiterplatte eindringt und so das Bauteil befestigt werden kann, wenn das elektrische Bauteil an die Leiterplatte angedrückt wird. In einer bevorzugten Ausgestaltung der Erfindung ist das Eingriffsmittel an einer Unterseite des Bauteils festgelegt. Das Eingriffsmittel ist vorzugsweise an der Unterseite des Bauteils angeordnet, die der Leiterplatte zugewandt ist und die nach Befestigung des Bauteils auf der Leiterplatte zumindest abschnittsweise aufliegt.

Ferner ist bevorzugt, dass das Eingriffsmittel als ein spitz zulaufender Zahn oder mehrere spitz zulaufende Zähne ausgestaltet ist. Das Eingriffsmittel kann beispielsweise als spitz zulaufender Zahn ausgestaltet sein, wobei es jedwede Form aufweisen kann, die selbstschneidend ausgebildet ist und somit ein Eindringen des Eingriffsmittels in die Leiterplatte ermöglicht. Das Eingriffsmittel kann beispielsweise durch Stanzen in das Bauteil eingebracht werden. Die Ausstanzung weist insbesondere eine Sternenform auf, die aus mehreren Zungen oder Bereichen besteht, wobei die Zungen oder Bereiche durch ein Werkzeug umgebogen werden können und so das Eingriffsmittel bilden. Somit kann das Eingriffsmittel auch als selbstschneidende Zungen, Zähne oder Bereiche bezeichnet werden, die spitz zulaufend ausgestaltet sind.

In einer Ausgestaltung des erfindungsgemäßen Bauteils ist vorgesehen, dass das Bauteil zwei zueinander beabstandet angeordnete Eingriffsmittel aufweist. Die Eingriffsmittel können mit Abstand zueinander auf dem Bauteil angeordnet sein, so dass eine dreh- und verschiebesichere Befestigung des Bauteils an der Leiterplatte erreicht wird.

Durch die erfindungsgemäße Ausgestaltung kann das Bauteil einfach, schnell und vor allem flexibel an der Leiterplatte befestigt werden. Es ist nicht nötig, den Bereich, der für die Befestigung des Bauteils vorgesehen ist, in irgendeiner Art vorzubereiten und beispielsweise vorzustanzen. Durch den Wegfall des Vorstanzens wird die Leiterplatte nicht unnötig mechanisch belastet. Zudem hat sich gezeigt, dass das Bauteil mit dem Eingriffsmittel durch ein Massenherstellungsverfahren einfach und kostengünstig hergestellt werden kann.

Es ist bevorzugt vorgesehen, dass das elektrische Bauteil kraftschlüssig an der Leiterplatte festgelegt ist. Dadurch, dass das Eingriffsmittel selbstschneidend ausgestaltet ist, dringt das Eingriffsmittel in die Leiterplatte, beziehungsweise ein Material einer Oberseite der Leiterplatte ein, wenn das Bauteil an die Leiterplatte angedrückt wird. Bekannte Leiterplatten weisen regelmäßig Bestandteile aus einem elastischen Material auf, so dass das Eingriffsmittel nach Eindringen in das Material der Leiterplatte durch die elastischen Eigenschaften des Materials in der Leiterplatte klemmend festgelegt wird. Durch das Ineinandergreifen des Eingriffsmittels und der Leiterplatte wird ein Kraftschluss hergestellt, der eine stabile Befestigung des Bauteils an der Leiterplatte sicherstellt.

Es kann jedoch auch bevorzugt sein, dass das elektrische Bauteil formschlüssig an der Leiterplatte festgelegt ist. Wenn das Bauteil an die Leiterplatte angedrückt wird, dringt das Eingriffsmittel in das Material der Leiterplatte ein. Diesbezüglich ist es vorteilhaft, wenn das Eingriffsmittel derart ausgestaltet ist, dass es die Leiterplatte vollständig durchdringt und die durchdringenden Bereiche des Eingriffsmittels, die auf einer einer Andrückseite entgegengesetzten Seite der Leiterplatte die Leiterplatte durchdringen, umgebogen werden. Durch das bereichsweise Umbiegen des Eingriffsmittels wird ein Formschluss zwischen der Leiterplatte und dem Bauteil hergestellt. Um eine Umbiegung des Eingriffsmittels zu vereinfachen, ist es bevorzugt, dass das Eingriffsmittel mindestens abschnittsweise biegbar ausgestaltet ist. Ein Bereich des Eingriffsmittels kann biegbar ausgestaltet sein, was beispielsweise durch eine fertigungstechnische Bearbeitung des Eingriffsmittels, beispielsweise eine abschnittsweise Falzung des Eingriffsmittels, beziehungsweise des biegbaren Bereichs, erreicht werden kann.

Die kraftschlüssige oder formschlüssige Festlegung des Bauteils benötigt keine weitere Bearbeitungsschritte oder ein zusätzliches Werkzeug. Auch eine Vorstanzung der Leiterplatte ist für die Befestigung des erfindungsgemäßen Bauteils nicht notwendig. Das Bauteil kann somit einfach und schnell an einer Leiterplatte angebracht werden.

Es kann bevorzugt sein, dass das Eingriffsmittel eine Durchtrittsöffnung zur Durchführung eines Befestigungsmittels aufweist. Fertigungstechnisch kann es vorteilhaft sein, wenn das Eingriffsmittel mittels eines Stanzvorgangs in das Bauteil eingebracht wird, wobei eine sternenförmige Stanzung bevorzugt ist. Der ausgestanzte Bereich weist insbesondere eine Durchtrittsöffnung auf. Das Eingriffsmittel kann beispielsweise umlaufend der Durchtrittsöffnung angeordnet sein. Um das Bauteil an einer Leiterplatte zu befestigen, die beispielsweise hohen Belastungen ausgesetzt ist, kann die Durchtrittsöffnung dazu verwendet werden, ein Befestigungsmittel durch das Bauteil in die Leiterplatte zu führen und eine weitere Befestigung zwischen Bauteil und Leiterplatte zu erreichen. Das Befestigungsmittel kann beispielsweise eine Schraube, eine Niete oder eine Klammer sein.

Um eine elektrische Verbindung zwischen dem elektrischen Bauteil und der Leiterplatte herzustellen, kann das Eingriffsmittel vorzugsweise elektrisch leitend ausgestaltet sein. Bevorzugt ist das Eingriffsmittel aus einem elektrisch leitfähigen Halbmetall, einem elektrisch leitfähigen Metall oder einer elektrisch leitfähigen Legierung gefertigt. Es kann jedoch auch bevorzugt sein, dass lediglich ein Bereich des Eingriffsmittels elektrisch leitend ausgestaltet ist oder das Eingriffsmittel eine elektrisch leitfähige Beschichtung aufweist.

Ferner kann vorgesehen sein, dass beabstandet zu dem Eingriffsmittel ein elektrisch leitender Kontaktbereich angeordnet ist. Der Kontaktbereich ist ein Bereich des elektrischen Bauteils und steht insbesondere mit der Leiterplatte, insbesondere mit elektrisch leitfähigen Bereichen der Leiterplatte in Wirkkontakt, so dass zwischen dem elektrischen Bauteil und der Leiterplatte eine elektrische Verbindung hergestellt werden kann. Der Kontaktbereich kann beispielsweise eine gewölbte, eine planare oder ebene Form aufweisen, wodurch eine elektrische Kontaktierung mit der Leiterplatte herstellbar ist.

Nachfolgend soll die Erfindung anhand von Figuren beispielhaft illustriert werden. Es zeigt:
- Fig. 1: eine Seitenansicht einer Ausgestaltung eines elektrisch leitfähigen Bauteils auf einer Leiterplatte,
- Fig. 2: eine Seitenansicht des in Fig. 1 dargestellten elektrisch leitfähigen Bauteils
- Fig. 3: eine Unteransicht des in den Fig. 1 und 2 dargestellten elektrisch leitfähigen Bauteils,
- Fig. 4: eine Seitenansicht eines abweichend ausgestalteten elektrisch leitfähigen Bauteils, und
- Fig. 5: eine Draufsicht auf das in Fig. 4 dargestellte elektrisch leitfähige Bauteil.

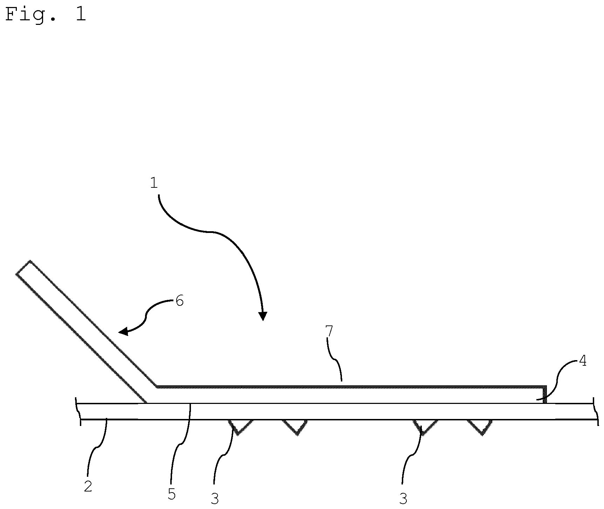

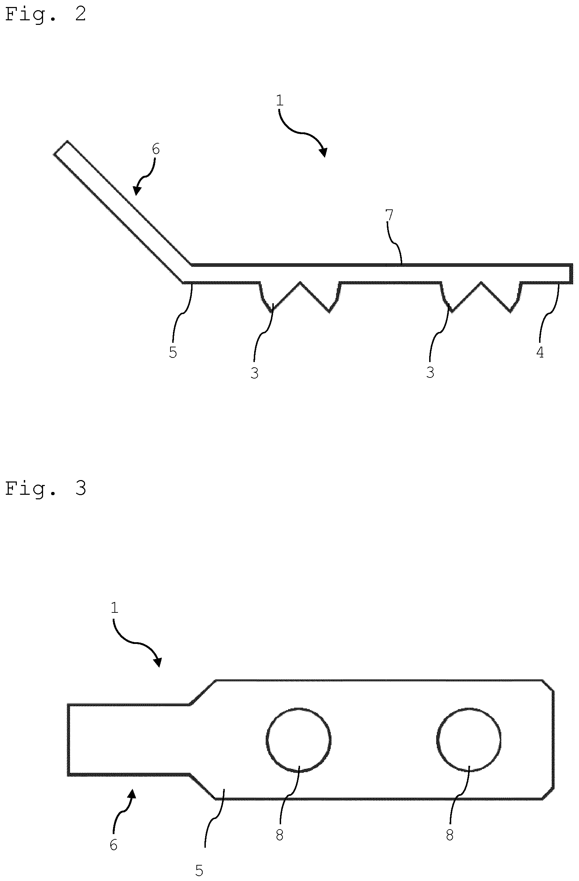

Fig. 1 zeigt eine Seitenansicht einer Ausgestaltung eines elektrisch leitfähigen Bauteils 1 auf einer Leiterplatte, Fig. 2 zeigt eine Seitenansicht des elektrisch leitfähigen Bauteils 1 und Fig. 3 stellt eine Unteransicht des elektrisch leitfähigen Bauteils 1 dar. Das elektrische Bauteil 1 zur elektrisch leitenden Anbringung an einer Leiterplatte 2 weist mindestens ein selbstschneidendes Eingriffsmittel 3 auf. Das Bauteil 1 kann beispielsweise ein Widerstand oder eine Lötfahne sein, die an einer Leiterplatte 2 angebracht werden. Das Eingriffsmittel 3 dringt in die Leiterplatte 2 ein, wenn das elektrische Bauteil 1 an die Leiterplatte 2 angedrückt wird, um das elektrische Bauteil 1 an der Leiterplatte 2 festzulegen. Das Eingriffsmittel 3 kann beispielsweise als selbstschneidende Zähne oder Zungen ausgestaltet sein, die dadurch entstehen, dass das Eingriffsmittel 3 mittels einer sternförmig ausgestalteten Stanzung in das Bauteil 1 eingebracht wird. Einzelne Segmente oder Bereiche der sternförmigen Stanzung können dann mittels einem Werkzeug umgebogen werden, so dass das Eingriffsmittel 3 an einer Unterseite 5 des Bauteils 1 festgelegt ist.

Um einen elektrischen Kontakt zwischen dem Bauteil 1 und der Leiterplatte 2 herzustellen, kann das Eingriffselement 3 elektrisch leitfähig sein und beispielsweise aus einem elektrisch leitfähigen Material bestehen. Ferner kann das Bauteil 1 beabstandet zu dem Eingriffsmittel 3 einen elektrisch leitfähigen Kontaktbereich 4 aufweisen, der die elektrische Kontaktierung zwischen Bauteil 1 und Leiterplatte 2 herstellt.

Das Bauteil 1 kann einen Kopfbereich 6 aufweisen, an dem ein elektrischer Leiter festgelegt werden kann. Der Kopfbereich 6 kann relativ zu einem Bereich des Bauteils 1, in dem das Eingriffselement 3 angeordnet ist, abgewinkelt sein.

Nachdem das Bauteil 1 mit dem Eingriffselement 3 an die Leiterplatte 2 angedrückt wird, dringt das Eingriffsmittel 3 in die Leiterplatte 2 ein. Diesbezüglich ist es vorteilhaft, wenn das Eingriffsmittel 3 derart ausgestaltet ist, dass es die Leiterplatte 2 vollständig durchdringt und die durchdringenden Bereiche des Eingriffsmittels 3, die auf einer einer Andrückseite 7 entgegengesetzten Unterseite 5 der Leiterplatte durch die Leiterplatte 2 dringen beziehungsweise hervorstehen, umgebogen werden. Durch das bereichsweise Umbiegen des Eingriffsmittels 3 wird ein Formschluss zwischen der Leiterplatte 2 und dem Bauteil 1 hergestellt. Das Bauteil 1 kann jedoch auch ohne ein Umbiegen eines Bereiches des Eingriffsmittels 3 an der Leiterplatte 2 kraftschlüssig befestigt sein. Das Bauteil 1 kann mehrere Eingriffsmittel 3 aufweisen, die beabstandet zueinander auf dem Bauteil 1 angeordnet sind.

Das Eingriffsmittel 3 kann eine Durchtrittsöffnung 8 zur Durchführung eines Befestigungsmittels aufweisen. Bei dem Stanzvorgang zur Herstellung des Eingriffsmittels 3 mittels einer sternenförmigen Stanzung, weist der ausgestanzte Bereich eine Durchtrittsöffnung 8 auf. Das Eingriffsmittel 3 kann beispielsweise umlaufend der Durchtrittsöffnung 8 angeordnet sein. Das Bauteil 1 kann somit in Ergänzung zu dem Eingriffsmittel 3 mit nicht dargestellten Befestigungsmitteln an der Leiterplatte 2 befestigt werden, wobei die Befestigungsmittel durch die Durchtrittsöffnung 8 durchgeführt werden. Das Befestigungsmittel kann beispielsweise eine Schraube, eine Niete oder eine Klammer sein.

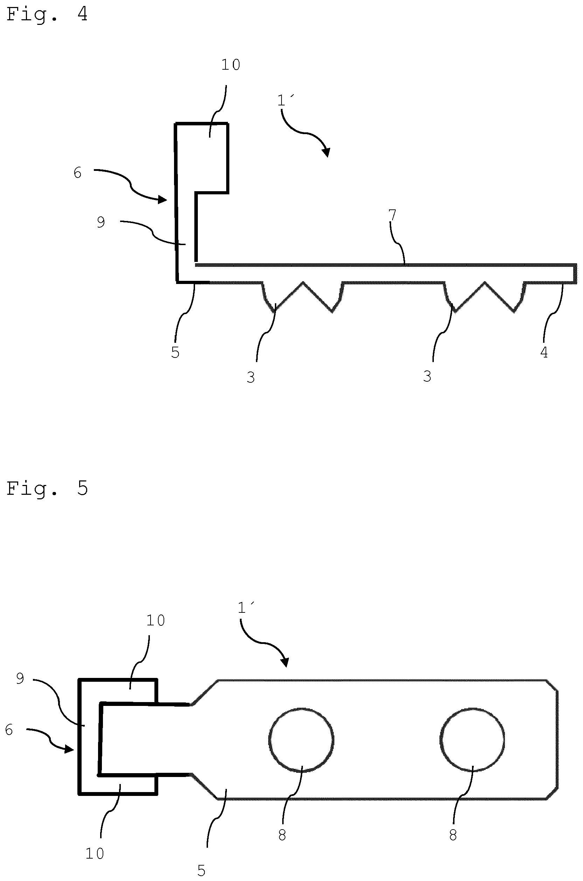

In den Fig. 4 und 5 ist exemplarisch eine abweichende Ausgestaltung eines elektrischen Bauteils 1' gezeigt. Der Kopfbereich 6 kann näherungsweise senkrecht von der Andrückseite 7 abstehen und ein Aufnahmeelement für einen mit der Leiterplatte 2 zu verbindenden elektrisch leitenden Draht oder für eine Litze bilden, wie sie beispielsweise ein Crimpkontakt aufweist. Zu diesem Zweck weist der Kopfbereich 6 eine senkrecht von der Andrückseite 7 abgewinkelte Basisplatte 9 auf. An gegenüberliegenden Seitenkanten der Basisplatte 9 ist jeweils eine ebenfalls senkrecht zu der Basisplatte 9 abgewinkelte Befestigungszunge 10 ausgebildet. Die Basisplatte 9 und die Befestigungszungen 10 können zusammen mit dem elektrisch leitenden Kontaktbereich 4 aus einem ebenen Metallblech ausgestanzt und in die gewünschte Formgebung abgewinkelt und verformt werden. Der elektrisch leitende Draht oder eine Litze können zur Befestigung an dem Bauteil 1' zwischen den beiden Befestigungszungen 10 angeordnet und anschließend die Befestigungszungen 10 mit einem geeigneten Werkzeug, beispielsweise mit einer Crimpzange, umgebogen und eng an den Draht oder die Litze anliegend zusammengepresst werden.

## Patentansprüche

1. Elektrisches Bauteil (1, 1') zur elektrischen Anbringung an einer Leiterplatte (2), wobei das elektrische Bauteil (1, 1') mindestens ein selbstschneidendes Eingriffsmittel (3) aufweist, wobei das Eingriffsmittel (3) in die Leiterplatte (2) eindringt, wenn das elektrische Bauteil (1) an die Leiterplatte (2) angedrückt wird, um das elektrische Bauteil (1, 1') an der Leiterplatte (2) festzulegen, **dadurch gekennzeichnet, dass** das elektrische Bauteil (1, 1') beabstandet zu den Eingriffsmitteln (3) einen Kopfbereich (6) zur elektrisch leitenden Festlegung eines elektrischen Leiters an dem elektrischen Bauteil (1, 1') aufweist.

2. Elektrisches Bauteil (1') nach Anspruch 1, **dadurch gekennzeichnet, dass** der Kopfbereich (6) eine Basisplatte (9) sowie seitlich abstehende Befestigungszungen (10) aufweist, die um einen zwischen den Befestigungszungen (10) angeordneten elektrischen Leiter gebogen und zusammengepresst werden können, um eine mechanisch stabile und elektrisch leitende Befestigung des elektrischen Leiters an dem Bauteil (1') zu erleichtern.

3. Elektrisches Bauteil (1, 1') nach Anspruch 1 oder Anspruch 2, **dadurch gekennzeichnet, dass** das elektrische Bauteil (1, 1') kraftschlüssig an der Leiterplatte (2) festgelegt ist.

4. Elektrisches Bauteil (1, 1') nach Anspruch 1 oder Anspruch 2, **dadurch gekennzeichnet, dass** das elektrische Bauteil (1, 1') formschlüssig an der Leiterplatte (2) festgelegt ist.

5. Elektrisches Bauteil (1, 1') nach einem der voranstehenden Ansprüche, **dadurch gekennzeichnet, dass** das Eingriffsmittel (3) elektrisch leitend ausgestaltet ist.

6. Elektrisches Bauteil (1, 1') nach einem der voranstehenden Ansprüche, **dadurch gekennzeichnet, dass** beabstandet zu dem Eingriffsmittel (3) ein elektrisch leitender Kontaktbereich (4) angeordnet ist.

7. Elektrisches Bauteil (1, 1') nach einem der vorangehenden Ansprüche, **dadurch gekennzeichnet, dass** das elektrische Bauteil (1, 1') zwei zueinander beabstandet angeordnete Eingriffsmittel (3) aufweist.

8. Elektrisches Bauteil (1, 1') nach einem der vorangehenden Ansprüche, **dadurch gekennzeichnet, dass** das Eingriffsmittel (3) an einer Unterseite (5) des Bauteils (1, 1') festgelegt ist.

9. Elektrisches Bauteil (1, 1') nach einem der vorangehenden Ansprüche, **dadurch gekennzeichnet, dass** das Eingriffsmittel (3) als ein spitz zulaufender Zahn oder mehrere spitz zulaufende Zähne ausgestaltet ist.

10. Elektrisches Bauteil (1, 1') nach einem der vorangehenden Ansprüche, **dadurch gekennzeichnet, dass** das Eingriffsmittel (3) mindestens abschnittsweise biegbar ausgestaltet ist.

11. Elektrisches Bauteil (1, 1') nach einem der vorangehenden Ansprüche, **dadurch gekennzeichnet, dass** das Eingriffsmittel (3) eine Durchtrittsöffnung (8) zur Durchführung eines Befestigungsmittels aufweist.

## Claims

1. An electrical component (1, 1') for electrical attachment to a circuit board (2), wherein the electrical component (1, 1') comprises at least one self-tapping engagement means (3), wherein the engagement means (3) penetrates into the circuit board (2) when the electrical component (1) is pressed against the circuit board (2) in order to fix the electrical component (1, 1') to the circuit board (2), **characterized in that** the electrical component (1, 1') spaced apart from the engagement means (3) comprises a head region (6) for the electrically conductive fixing of an electrical conductor to the electrical component (1, 1').

2. The electrical component (1') according to claim 1, **characterized in that** the head region (6) comprises a base plate (9) and laterally projecting mounting tabs (10) which can be bent and pressed together around an electrical conductor arranged between the mounting tabs (10) to facilitate a mechanically stable and electrically conducting attachment of the electrical conductor to the component (1').

3. The electrical component (1, 1') according to claim 1 or claim 2, **characterized in that** the electrical component (1, 1') is fixed in a force-fitting manner to the circuit board (2).

4. The electrical component (1, 1') according to claim 1 or claim 2, **characterized in that** the electrical component (1, 1') is fixed in a form-fitting manner to the circuit board (2).

5. The electrical component (1, 1') according to one of the preceding claims, **characterized in that** the engagement means (3) is electrically conductive.

6. The electrical component (1, 1') according to one of the preceding claims, **characterized in that** an electrically conducting contact region (4) is arranged spaced from the engagement means (3).

7. The electrical component (1, 1') according to one of the preceding claims, **characterized in that** the electrical component (1, 1') comprises two engagement means (3) spaced from each other.

8. The electrical component (1, 1') according to one of the preceding claims, **characterized in that** the engagement means (3) is fixed on an underside (5) of the component (1, 1').

9. The electrical component (1, 1') according to one of the preceding claims, **characterized in that** the engagement means (3) is designed as a tapered tooth or a plurality of tapered teeth.

10. The electrical component (1, 1') according to one of the preceding claims, **characterized in that** the engagement means (3) is designed at least bendable in regions.

11. The electrical component (1, 1') according to one of the preceding claims, **characterized in that** the engagement means (3) comprises a passage opening (8) for the passage of a fastening means.

## Revendications

1. Composant électrique (1, 1') pour la pose électrique sur une carte électronique (2), le composant électrique (1, 1') comprenant au moins un moyen de mise en prise (3) autotaraudeur, le moyen de mise en prise (3) pénétrant dans la carte électronique (2) lorsque le composant électrique (1) est pressé contre la carte électronique (2) pour fixer le composant électrique (1, 1') sur la carte électronique (2), **caractérisé en ce que** le composant électrique (1, 1') comprend, espacée des moyens de mise en prise (3), une zone de tête (6) pour une fixation électroconductrice d'un conducteur électrique sur le composant électrique (1, 1').

2. Composant électrique (1') selon la revendication 1, **caractérisé en ce que** la zone de tête (6) comprend une plaque de base (9) ainsi que des pattes de fixation (10) faisant saillie latéralement qui peuvent être pliées autour d'un conducteur électrique disposé entre les pattes de fixation (10) et comprimées afin de faciliter une fixation mécaniquement stable et électroconductrice du conducteur électrique sur le composant (1').

3. Composant électrique (1, 1') selon la revendication 1 ou la revendication 2, **caractérisé en ce que** le composant électrique (1, 1') est fixé par liaison de force sur la carte électronique (2).

4. Composant électrique (1, 1') selon la revendication 1 ou la revendication 2, **caractérisé en ce que** le composant électrique (1, 1') est fixé sur la carte électronique (2) par adhérence de forme.

5. Composant électrique (1, 1') selon l'une quelconque des revendications précédentes, **caractérisé en ce que** le moyen de mise en prise (3) est conçu de manière à être électroconducteur.

6. Composant électrique (1, 1') selon l'une quelconque des revendications précédentes, **caractérisé en ce qu'**une zone de contact (4) électroconductrice est disposée de manière distante au moyen de mise en prise (3).

7. Composant électrique (1, 1') selon l'une quelconque des revendications précédentes, **caractérisé en ce que** le composant électrique (1, 1') présente deux moyens de mise en prise (3) disposés de manière distante l'un de l'autre.

8. Composant électrique (1, 1') selon l'une quelconque des revendications précédentes, **caractérisé en ce que** le moyen de mise en prise (3) est fixé sur un côté inférieur (5) du composant (1, 1').

9. Composant électrique (1, 1') selon l'une quelconque des revendications précédentes, **caractérisé en ce que** le moyen de mise en prise (3) est conçu comme une dent pointue ou plusieurs dents pointues.

10. Composant électrique (1, 1') selon l'une quelconque des revendications précédentes, **caractérisé en ce que** le moyen de mise en prise (3) est conçu de manière à pouvoir être plié, au moins par sections.

11. Composant électrique (1, 1') selon l'une quelconque des revendications précédentes, **caractérisé en ce que** le moyen de mise en prise (3) présente une ouverture de passage (8) afin de guidage à travers d'un moyen de fixation.
